# EUROPEAN PATENT APPLICATION

(11) **EP 4 273 295 A1**
(43) Date of publication of application: **08.11.2023**
(21) Application number: 22382422.8
(22) Date of filing: 03.05.2022
(51) Int. Cl.: C23C 14/24

(54) **IMPROVED SYNTHESIS PROCESS OF THIN FILMS BY VAPOUR DEPOSITION**

(71) Applicant: Universitat de València, 46010 Valencia (ES)
(72) Inventor: RODKEY, Nathan Jacques, 46010 Valencia (ES); HUISMAN, Bas Antonius Hendrikus, 46010 Valencia (ES); BOLINK, Hendrik Jan, 46010 Valencia (ES)
(74) Representative: Elzaburu S.L.P.

(57) **Abstract**

The present invention relates to a process for obtaining thin films from powders of inorganic and organic materials by vapour deposition, characterized in that the crucible used to heat the powders is pre-heated above their sublimation temperature and in that this powder is fed in µg/pulse quantities to the pre-heated crucible by a feeder system. Furthermore, the invention is related to a device to carry out this process.

## Description

### FIELD OF THE INVENTION

The present invention relates to a process for obtaining thin films from powders of inorganic and organic materials by vapour deposition, characterized in that the crucible used to heat the powders is pre-heated above their sublimation temperature and in that this powder is fed in µg/pulse quantities to the pre-heated crucible by a feeder system. Furthermore, the invention is related to a device to carry out this process. Therefore, the present invention relates to the field of the manufacture of thin films.

### BACKGROUND OF THE INVENTION

The preparation of uniform thin films without the use of solvents is crucial for a wide range of applications, ranging from coatings to semiconductor devices. Typical semiconductor-based devices are, transistors, light emitting diodes and solar cells. Solar cells, herein referred to as photovoltaic (PV) cells, are devices that convert photo-energy from the sun into electrical energy. In order to prepare high performance coatings, LEDs and solar cells, homogeneous films are needed.

Organic-inorganic (hybrid) lead halide perovskite (from now on referred to as "perovskite") solar cells have been proposed for photovoltaic applications because of their impressive power conversion efficiencies (PCEs), now exceeding 25% (see Kojima et al., J. Am. Chem. Soc. 131, 6050-6051 (2009); Lee et al., Science 338, 643-647 (2012); Min, H., et al. Nature 598, 444-450 (2021)). High quality perovskite films with a high degree of crystallinity are needed in order to reduce the trap concentration and achieve an adequate mobility of the charge carriers (see Nie et al., Science 347, 522-525 (2015)). Perovskites, specifically inorganic-organic hybrids, are primarily prepared into thin films via solution-based processes, where precursors or perovskite powders are dissolved in a solution before coating onto a substrate. Coating from solutions has its limitations, primarily due to the need to use coordinating solvents to dissolve the inorganic precursors salts. These solvents, such as dimethylformamide (DMF) or dimethylsulfoxide (DMSO) have a high boiling point which makes it difficult to completely remove them from the finished film. Additionally, these solvents are harmful. For example, DMF has recently been banned for industrial production by the EU. An alternative processing method to prepare perovskite thin films is via vacuum-based processes. These are solvent free processes that and widely used in industrial application. Vacuum processes, such as evaporation, have a proven scalability, being used in many industrial processes from microelectronics, organic PV, and industrial silicon solar cell production lines. On top of this, evaporation is a conformal coating process, able to deposit uniform films on textured surfaces, most relevant when partnering perovskite to the textured silicon surfaces for tandem designs. This patent will focus on a vacuum-based deposition technique for these reasons.

The development of perovskites with vacuum-based technologies has not been straightforward. This is largely due to the organic compounds involved in the process (e.g. methylammonium (MA) and formamidinium (FA) salts), which are needed to give the highest efficiency devices. Prolonged heating of these organic salts close to their sublimation temperatures leads to their decomposition. This implies that for each sublimation process pristine materials must be introduced into the crucibles. In an industrial tool, this would severely limit the production yield and make the process uneconomical. Vacuum assisted coating processes are used extensively to prepare thin films of materials. The materials are usually present in the solid state, as powders or pressed into high density pellets. These powders or pellets are then heated above their sublimation temperature using either one of the following energy sources, resistive heating, laser induced heating or via bombardments with high energy ions. In many applications, resistive heating is used and in these cases the powder is deposited in the crucible prior to heating it up. In many applications, the powder is maintained close to their sublimation temperature for prolonged periods. This can lead to degradation of the material and loss of performance of the devices incorporating the thin films.

If the powder is a material consisting of different components such as a perovskite, then the composition of the powder can change as components with lower sublimation temperatures sublime first. If the powder consists of organic salts, the sublimation behaviour is not always very controllable. For example, alkylammonium bromide salts have an unstable evaporation rate. These unstable rates indicate that degradation mechanisms dominate at temperatures lower than their sublimation points. This is usually seen as a spike in the pressure, accompanied by a small, to non-existent deposition rate. Examples of two of these unstable bromide salts are formamidium bromide and methylammonium bromide (FABr and MABr, respectively).

The complexity of perovskite compositions, and the number of compounds found in high efficiency cells, has increased over the last years. The highest efficiency cells typically contain mixtures of 5 cations and 2 or 3 anions (precursors) that form into a complex perovskite. It is possible to heat powders of these precursors in different crucibles, however, this requires the use of 4 to 8 sources. Controlling these sublimation sources reliably over long durations of time is very challenging. Especially, in the case of organic halide salts as these are degrading (slowly) at high temperatures.

It is possible to prepare perovskite powders, including those with complex compositions using mechano-synthesis by mixing the precursor salts in a ball-milling device (F. Palazon, et al., Adv. Energy Mater., 10, 13, 1902499 (2019)). One alternative to multiple source sublimation is to combine the perovskite precursors or perovskite pre-synthesized powders (from now on referred to as "perovskite formulation") in one source and intend to sublime them all at once. This process is referred to as single source vapour deposition (SSVD). In most cases in SSVD a pre-synthesized perovskite powder is placed in a crucible that is placed into an evaporation source inside a vacuum chamber. After lowering the pressure of the vacuum chamber, the source is rapidly heated and the material inside the crucible will sublime leading to the deposition of thin films on the substrate. However, SSVD has important limitations as degradation of the powder and sublimation occur simultaneously. This leads to irreproducible films that are not suitable for industrial processes.

A second alternative is similar to SSVD but now the powders are evaporated at temperatures much higher than their sublimation points. This method is referred to as flash evaporation. If the temperature of the source can increase fast enough it is in principle possible to avoid degradation by evaporating the material faster than their degradation pathways can come into effect. It is, however, not easy to increase the source temperature fast enough. Additionally, in the flash evaporation processes there is no control on evaporation rates, which leads to non-uniform films when thicknesses above 100 nm are targeted. Additional problems occur when larger amounts of materials need to be deposited as than decomposition of part of the powder occurs while another part is subliming. Also the film morphology is not easy to control.

Document WO2020/210399 discloses a vapour phase deposition method to obtain perovskite semiconductors. This method may be configured to support liquid and solid precursors and can utilize a single powdered perovskite source to provide a continuous feed of precursors (see for example paragraph [0050]). The powder falls into a material feeder which meters the output of perovskite constituent powders. There is no description of controlling small quantities of powder in ug or mg doses, which is an essential element to control the deposition rates and the quality of the deposited thin films.

Document EP3506378 discloses a device for improving perovskite film formation uniformity in deposition processes. The device allows to add the precursor powder into the mould and heat it, although the powder feeding is not controlled. This patent does not describe an incremental powder feeding mechanism. Powder feeding is not controlled which is an essential element to control the deposition rates and the quality of the deposited thin films.

Document US2021242357 discloses thermal evaporation chambers for vapor-deposition of metal-halide semiconductors such as lead-halide perovskites. Some of the deposition chamber comprises a powder feeder which deposits the source powder into an evaporation boat connected to a thermal heater so that the source material is rapidly evaporated/sublimated upon contact with the heating element. A schematic of a method to feed powder is mentioned, yet not in microgram scale which is an essential element to control the deposition rates and the quality of the deposited thin films.

### DESCRIPTION OF THE INVENTION

The present invention overcome the disadvantages of the vapour evaporation process by decoupling the heating of the source from the presence of the powders. This is achieved by slowly feeding the powder into a pre-heated source. The source temperature is placed above the sublimation temperature of each of the components comprising the powder. The evaporation rate is controlled by the speed of the powder feeder into the heated crucible.

Thus, a first aspect of the invention refers to a process to obtain thin films from powders of inorganic and/or organic materials by a vapour deposition method characterized in that it comprises the following steps:
a) the crucible for the powder or powders is pre-heated above the sublimation temperature of said powder or powders which are going to be used before introducing them into the crucible;
b) the powder or powders are fed in µg/pulse quantities to the pre-heated crucible by a feeder system.

In the present invention, µg/pulse quantities may be understood as a selected amount of µg which is extracted from the powder and deposited onto the crucible by the feeder system. These selected amounts in the µg range may be adjusted depending on the nature of the powders and the characteristics of the final product to be obtained.

Preferably, the vapour deposition method is flash evaporation (FE).

Preferably, the powders are selected from perovskites powders, perovskite precursors or organic semiconductors. More preferably, the powders are perovskite or perovskite precursor powders.

In the present invention, perovskite is understood as a compound that typically take the form of an ABX₃ crystal structure with A being a +1 cation, B a +2 cation, and X being a -1 anion. This can be with any combination of elements as well as in the double-perovskite permutations which take on a A₂BB'X₆ form where B and B' are replaced with +1 and +3 cations respectively.

Organic semiconductors are molecules that consist of a conjugated region and are capable of transporting holes or electrons, such as for example triphenylamine, carbazole, (N,N,(diphenyl)-N',N'di-(alkylphenyl)-4,4'-biphenyldiamine), (pTPDs), diphenylhydrazone, etc., and perylene's, fullerenes, fullerenones, etc i.e. as described for example in the book: "Organic Photoreceptors for Imaging Systems", appendix 3, by Paul M. Borsenberger and David S. Weiss, Marcel Dekker, Inc, NY 1998.

The perovskite may have a stoichiometry of AMX₃ or A₂MX₄, where "A" and "M" are cations and "X" is an anion. The "A" and "M" cations can have a variety of charges and in the original Perovskite mineral (CaTiO₃), the A cation is monovalent and the M cation is bivalent. The term "perovskite" as used here refers to the "perovskite crystal structure", but not limited to the specific structure of the perovskite material, CaTiO₃. "Perovskite" may encompass any material that has the same type of crystal structure as calcium titanium oxide, and materials in which the bivalent cation is replaced by two separate monovalent cations. The perovskite formulae as used here may include structures having three or four anions, which may be the same or different, and/or one or two organic cations, and / or metal atoms carrying two or three positive charges. Organic-inorganic perovskites are hybrid materials exhibiting combined properties of organic composites and inorganic crystallinity. The inorganic component forms a framework bound by covalent and ionic interactions, which provide high carrier mobility. The organic component helps in the self-assembly process of those materials. It also enables the hybrid materials to be deposited by low-cost technique as other organic materials. Additional important property of the organic component is to tailor the electronic properties of the organic-inorganic material by reducing its dimensionality and the electronic coupling between the inorganic sheets.

In another embodiment, A is a monovalent or bivalent cation.

In another embodiment, A is selected from the group of monovalent or bivalent ammonium cations and alkali metal cations and alkaline earth metal cations.

In a preferred embodiment A is independently selected from organic, monovalent cations selected from primary, secondary, tertiary or quaternary organic ammonium compounds, including N-containing heterorings and ring systems, A having from 1 to 60 carbons and 1 to 20 heteroatoms; or being an organic, bivalent cation selected from primary, secondary, tertiary or quaternary organic ammonium compounds having from 1 to 60 carbons and 2 to 20 heteroatoms and having two positively charged nitrogen atoms; or being selected from the group of alkaline metals and/or alkaline earth metals.

In a particularly preferred embodiment A is the methyl ammonium (MA) cation [(CH₃)₃N]⁺ or alkali metal cation or a combination thereof.

In another embodiment, M is a divalent metal cation or a trivalent metal cation.

In another embodiment, M is a divalent metal cation selected from the group consisting of Cu²⁺, Ni²⁺, Co²⁺, Fe²⁺, Mn²⁺, Cr²⁺, Pd²⁺, Cd²⁺, Ge²⁺, Sn²⁺, Pb²⁺, Eu²⁺, or Yb²⁺ or a trivalent metal cation selected from the group consisting of Bi³⁺ and Sb³⁺.

In a particularly preferred embodiment, M is selected from the group consisting of Pb²⁺ and Sn²⁺.

In another embodiment X is a monovalent anion.

In another embodiment X is independently selected from Cl⁻, Br⁻, I⁻, NCS⁻, CN⁻, and NCO⁻.

In a particularly preferred embodiment, X is selected from I⁻, CI⁻, and Br⁻. Precursors to be used may be those known in the art such as, but not limited to, formamidine hydroiodide (FABr), methylammonium bromide (MABr), methylammonium chloride (MACI), methylammonium lead iodide (MAPI), phenylethylamine (PEA), phenylethylamine-bromide (PEA-Br), triphenylphosphine oxide (TPPO), sulphur-based compounds (e.g. Ag₃SI perovskite). Preferably, the perovskite formulations powder are those which comprise methylammonium (MA) and/or formamidinium (FA) salts and more preferably those which comprise methylammonium bromide (MABr) and/or formamidinium bromide (FABr) salts.

Preferably, the feeder system is selected from a rotating screw feeder or a vibratory feeder. More preferably the feeder system is an auger screw.

Preferably, the powder is dosed on a microgram-scale using pulsed-vibration.

Preferably, the process of the invention is carried out under vacuum.

Another aspect of the invention refers to a device (100) for obtaining thin films from powders of inorganic and organic materials, characterized in that it comprises:
- a hopper (101) comprising at least a vibration motor,
- an auger screw (102) connected to a motor and attached to the low part of the hopper (101), said auger screw (102) being configured to collect the powder introduced trough the hopper (101) and
- a ramp (103) connected to the end of the auger screw (102) and configured to collect the powders from the auger screw (101) and to dispense said powder to a pre-heated crucible.

Preferably, this device may comprise a housing (104) for the motor connected to the auger screw (102).

Preferably, the hopper (101) comprises at least a holder (105) to place a vibration motor.

Preferably, the device comprises a housing (106) for the auger screw (102).

Preferably, the device comprises an adaptor (107) to hold the auger screw (102).

Any of the powders described above can be used in the device of the invention, although other type of powders to obtain thin films may be considered.

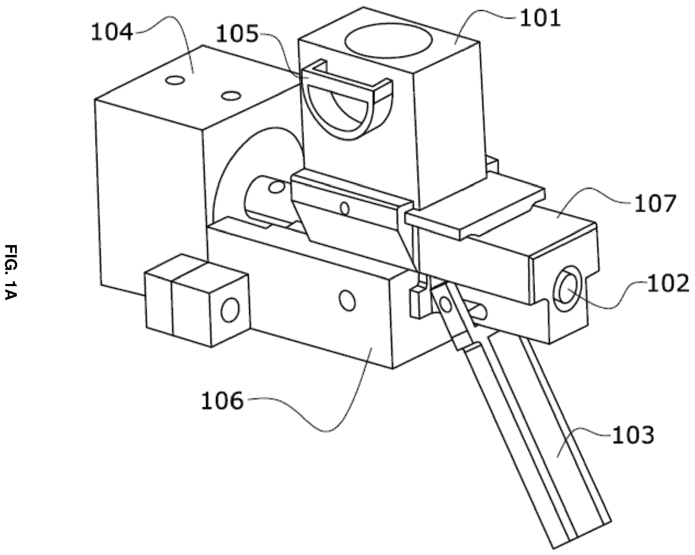

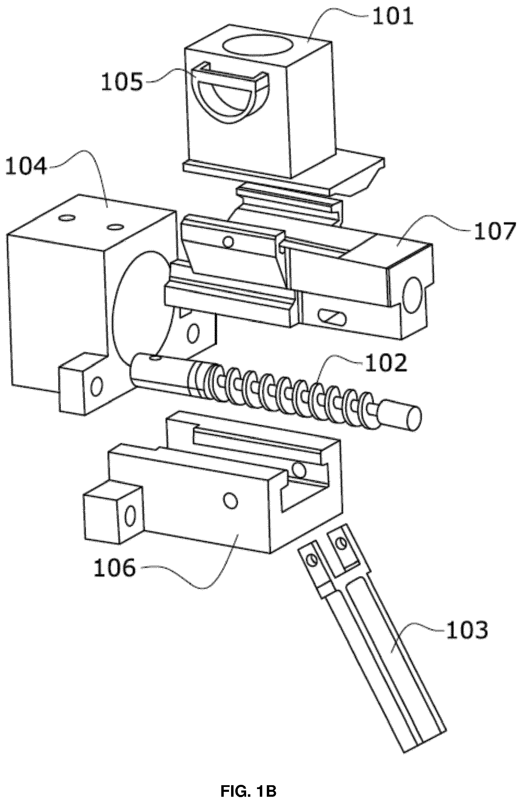

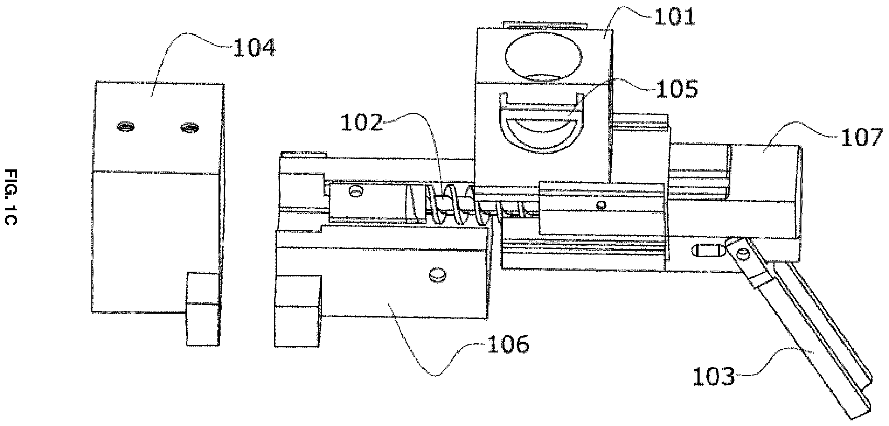

To carry out the process of the invention, it has been designed a special apparatus that enables the controlled supply of the powders into a pre-heated crucible inside a high vacuum chamber. This enables us to deposit smooth perovskite films with thicknesses above 100 nm that are used to prepare solar cells and light emitting diodes. The apparatus consists of at least six mechanical components, displayed in Figures 1A, 1B and 1C. The shape of the ramp (103) is kept spherical to avoid powder adhesion. The powder for evaporation is placed into the powder hopper (101) and dispensed using a pulse signal generator to create an on-off switch. This feeds powder into the auger screw (102), which is itself attached to a DC motor with a separate voltage generator, and carries the powder to the ramp, which dispenses the powder into a heated crucible. In this way, it is achieved microgram levels of control on the feed-rate of powders for a flash-evaporation process.

By introducing powder incrementally, in µg quantities, the invention is able to address the problems of rampant sputtering, competing degradation pathways, and limited film thicknesses that current flash evaporation processes are combatting. In this way we are able to report the formation of perovskites with as many as six components, as a single-source, sputter-free process, and demonstrate their performance in devices.

### BRIEF DESCRIPTION OF FIGURES

**Figures 1A****,** **1B****,** **1C****:** The custom-built incremental flash feeder system pictured as a Solidworks model. The components of the design; the auger screw, hopper, ramp, motor housing, adaptor, and screw housing are labelled. For the pulsed vibration, coin motors are placed on either side of the hopper.
**Figure 2****:** Flash-evaporation of MAPI with a frequency of 0.167 Hz, leading to powder being dispensed every 6 seconds. These principal peaks are marked by dashed lines. In solid red lines, split-peaks can be observed, linked to the periodicity of the Auger screw (1.7 s).
**Figure 3****:** Flash-evaporation of FAPbBr₃ with a frequency of 250 mHz, leading to powder being dispensed every 4 seconds. These principal peaks are marked by dashed lines.
**Figure 4****:** a) the photoluminescence and absorbance for FAPbBr₃ and MAPI and b) the XRD with ICSD references.
**Figure 5****:** The device characteristics of FAPbBr₃ films deposited using the invention. The dependence on organic cation excess is shown with a notable increase in the V_{oc} with increasing organic cation excess. The best performing device is reported at 4%.
**Figure 6****:** XRD patterns of a FAₓMA₁₋ₓPb_{0.6}Sn_{0.4}I₆ perovskite using a perovskite formulation powder that is **a)** stoichiometric powder **b)** thin-films of 100 nm deposited using the invention and with varying organic cation excesses, noting the decreasing Pbl₂ peak as organic cation excess goes up.
**Figure 7****:** XRD pattern of a 150 nm PEA-Br film deposited using the invention.
**Figure 8****:** Ultraviolet-visible absorption spectrum of a NDP film with a thickness of 42 nm deposited using the method of the invention.

### EXAMPLES

### Example 1: obtaining perovskites with the process of the invention.

FAPbBr₃, MAPI, and FaₓMA_{y}Pb_{0.6}Sn_{0.4}I₃:SnF₂ powders were ball-milled for 30 minutes with different excesses of the A-site cation (FA and/or MA), and then sieved through a 150 µm mesh before use in the incremental feeder system. Throughout this work, this excess A-site cation will be referred to as a ratio of AX:BX₂. The FAPbBr₃ powders were baked in a nitrogen glovebox at 65 °C for 12 hours before sieving. This baking was found to be critical for the FAPbBr₃ powder preparation, as the FABr precursor is especially hydroscopic. All powders were verified by x-ray diffraction (XRD) to check for the proper phase. This includes, before and after baking and with different amounts of organic-cation excess. For all scenarios, no noticeable differences were observed in the XRD patterns, and they closely followed their ICSD references.

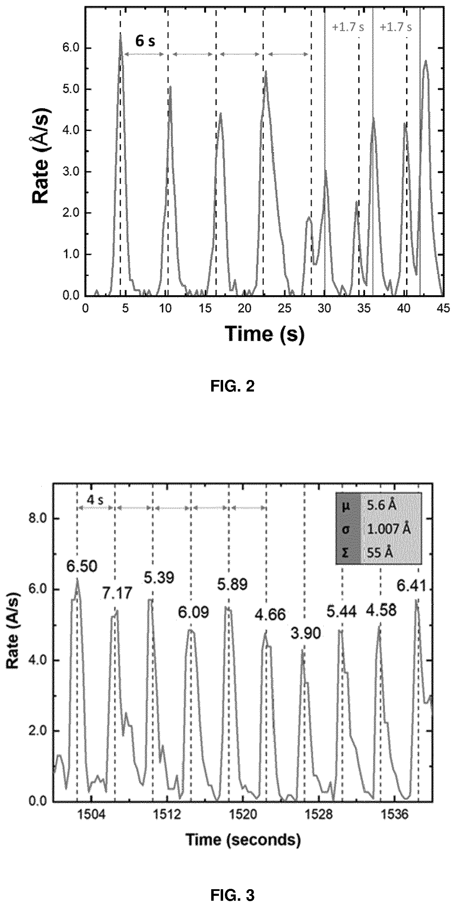

These powders are fed into the incremental feeder system, pictured in Figure 1. It consists of an auger screw connected to a DC motor, fixed at 3 V which leads to a periodicity of ~1.7 seconds (i.e. time for one full rotation of the screw). The vibration motors are controlled by pulse-width modulation (PWM), vibrating at a frequency of 250 mHz unless otherwise stated, with a duty cycle tuned between 4-30% (i.e. the coins vibrate 4-30% of the time during a 4-second interval). With this system, the deposition rates can be tuned through any combination of hopper orifice size, duty cycle, and vibration motor voltage. The rates achieved depend on the powder stoichiometry and preparation. An example of this rate is shown in figure 3, with FAPbBr₃ and in figure 2 with MAPI.

The resulting evaporation yields a "spikey" rate as the deposition is an instantaneous (as opposed to continuous process). A brief description is as follows; every 4-seconds (e.g. 250 mHz) a spike in the evaporation-rate is observed, with an occasional split-peak observed as well, tied to the periodicity of the auger screw.

The system-dependent trends observed here are good news for incremental flash-evaporation processes, as the flash-evaporation temperature can be tuned to mitigate sputtering for that system, rather than a set of individual components.

### Example 2: obtaining a thin film with the process of the invention

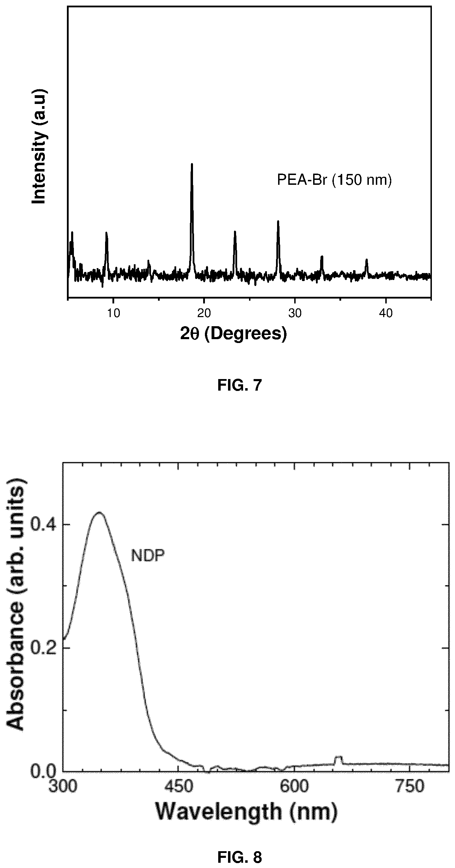

PEA-Br powders were sieved through a 150 µm mesh. These powders were fed into the incremental feeder system as described in Example 1 using a crucible temperature of 200 degrees Celsius. The ensuing rates for PEA-Br, when averaged over time, were >0.6 A/s and a film of 150 nm was deposited in this way. The XRD shown in Figure 7 proves the formation of a PEA-Br.

This process was repeated for a typical organic semiconductor N,N'-Di(1-naphthyl)-N,N'-diphenyl-(1,1'-biphenyl)-4,4'-diamine (NDP) powders that were sieved through a 150 µm mesh. These powders were fed into the incremental feeder system as described in Example 1 using a crucible temperature of 220 degrees Celsius, yielding a 24 nm film, with the accompanying UV-Visible absorption spectrum shown in Figure 8.

### Example 3: study of the obtained thin films

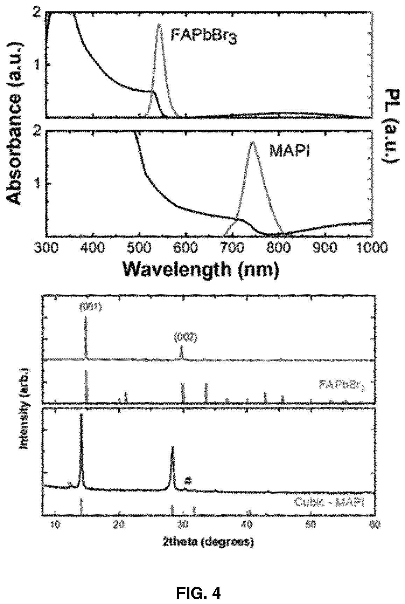

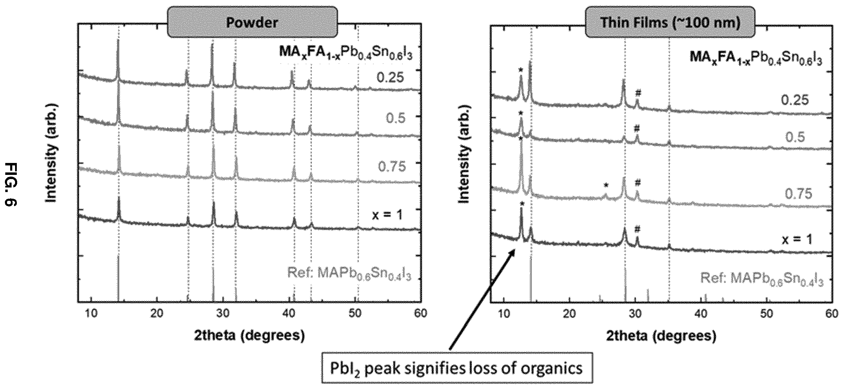

Once an appropriate flash-evaporation temperature is identified, thin-films of FAPbBr₃, MAPI, and MAₓFA_{y}Pb_{0.6}Sn_{0.4}I₃:SnF₂ were deposited, verified by photoluminescence and x-ray diffraction (Fig. 4 and 6). For FAPbBr₃ and MAPI, the PL peaks are centred at 542 and 760 nm respectively, correlating well to those found in literature. PL-mapping was used to probe the nature of sputtered, spherical particles, and were shown to brightly luminesce, with a peak position at 550 nm. This slight shift from reported values for FAPbBr₃ is common for strained or off-stoichiometric systems and demonstrates that the sputtered particles are crystalline in nature.

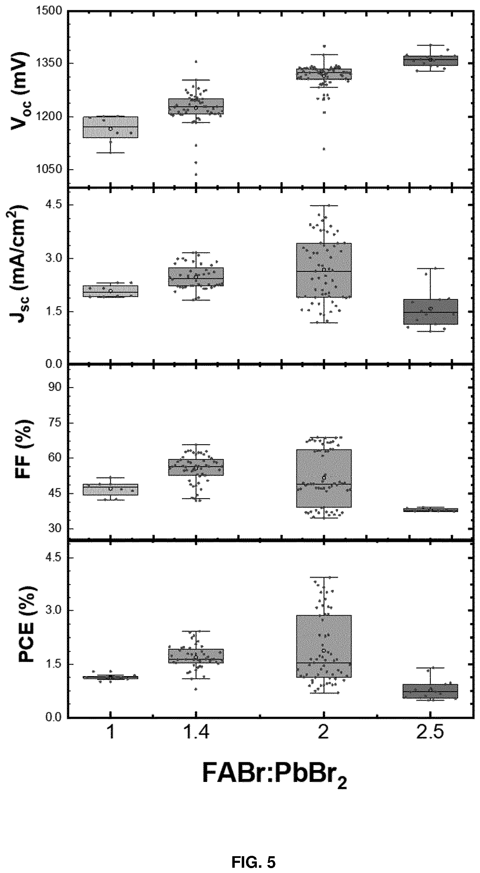

All devices demonstrated with this technology employed the same device structure. That is, a glass/ITO (indium tin oxide) substrate with an evaporated MoOₓ/TaTm (Tatm is a derivative of an arylamine (N4,N4,N4",N4"-tetra([1,1' -biphenyl]-4-yl)-[1,1':4',1"-terphenyl]-4,4"-diamine) stack with thicknesses of 6 and 10 nm respectively. This stack was annealed for 10 minutes at 200 °C in a nitrogen environment. The perovskite layer was then incrementally flash-evaporated to form a -200-500 nm layer using the invention described previously. This is followed by the evaporation of a C₆₀/BCP (bathocuproine) stack of 25 and 7 nm respectively. The device is then finished with an evaporated 100 nm Ag coating. Figure 5 shows the device performance where a notable increase in V_{oc} from 1.17 to 1.36 V is observed moving from a 1:1 to 2.5:1 organic-cation excess. This can be an indication of material quality, and/or passivation of grain boundaries as reported by other groups. The best device is reported at an excess of 2:1, with a power conversion of efficiency (PCE) of 4%.

MAPI devices were fabricated as described above with a maximum efficiency of 9.9% (Figure 6). the crystallinity, as seen in the XRD, of the as-deposited films was severely affected by organic-cation excesses greater than 1.5:1. Parallel to this, it was found that with increasing organic-cation excess the sputtering became more severe and may be linked to the shifting volatility of the system, seen in the high-vacuum TGA data described previously.

The examples of the invention demonstrate a controlled method for incremental powder feeding for flash-evaporation, and the successful transfer of up to 5 elements. This was studied for several material systems including FAPbBr₃, MAPbI₃ and FaₓMA_{y}Pb_{0.6}Sn_{0.4}I₃:SnF₂). The MAPbI₃ and FAPbBr₃ films were demonstrated in devices, with efficiencies of 10 and 4% respectively (Table 1).

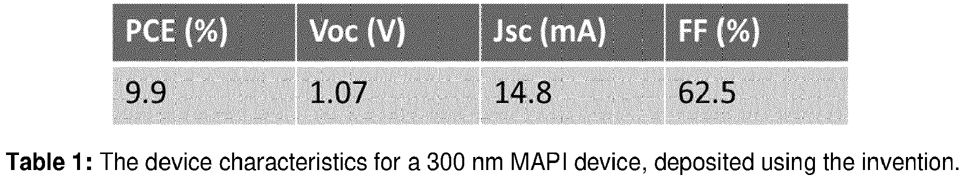

## Claims

1. A process to obtain thin films from powders of inorganic and/or organic materials by a vapour deposition method **characterized in that** it comprises the following steps:
a) the crucible for the powder or powders is pre-heated above the sublimation temperature of said powder or powders which are going to be used before introducing them into the crucible;
b) the powder or powders are fed in µg/pulse quantities to the pre-heated crucible by a feeder system.

2. The process of claim 1, wherein the vapour deposition is flash evaporation (FE).

3. The process of any ones of claim 1 or 2, wherein the powders are perovskite powders.

4. The process of any ones of claim 1 or 2, wherein the powders are perovskite precursors.

5. The process of any ones of claim 1 or 2, wherein the powders are organic semiconductors.

6. The process according to any one of the previous claims, wherein the feeder system is selected from a rotating screw feeder or a vibratory feeder.

7. The process according to claim 6, wherein the feeder system is an auger screw.

8. The process according to any one of the previous claims, wherein the powder is dosed on a microgram-scale using pulsed-vibration.

9. The process according to claim 4, wherein the perovskite powder comprises methylammonium (MA) and/or formamidinium (FA) salts, preferably the perovskite formulations powder comprises methylammonium bromide (MABr) and/or formamidinium bromide (FABr) salts.

10. The process according to any one of the previous claims, wherein it is carried out under vacuum.

11. A device for obtaining powders of inorganic and/or organic materials (100), **characterized in that** it comprises:
- a hopper (101) comprising at least a vibration motor,
- an auger screw (102) connected to a motor and attached to the low part of the hopper (101), said auger screw (102) being configured to collect the powder introduced trough the hopper (101) and
- a ramp (103) connected to the end of the auger screw (102) and configured to collect the powder precursors from the auger screw (101) and to dispense said powder to a pre-heated crucible.

12. The device according to claim 11 comprising a housing (104) for the motor connected to the auger screw (102).

13. The device according to any of claims 11 or 12 in which the hopper (101) comprises at least a holder (105) to place a vibration motor.

14. The device according to any of claims 11 to 13 comprising a housing (106) for the auger screw (102).

15. The device according to any of claims 11 to 14 comprising an adaptor (107) to hold the auger screw (102).
